# NEUE EUROPÄISCHE PATENTSCHRIFT

(11) **EP 3 705 854 B2**
(45) Veröffentlichungstag und Bekanntmachung des Hinweises auf die Entscheidung über den Einspruch: **02.12.2026**
(45) Hinweis auf die Patenterteilung: 05.06.2024
(21) Anmeldenummer: 20158065.1
(22) Anmeldetag: 18.02.2020
(51) Int. Cl.: G01F 15/00

(54) **FLUIDZÄHLER**
FLUID METER
COMPTEUR DE FLUIDE

(30) Priorität: 07.03.2019 DE 102019001590
(43) Veröffentlichungstag der Anmeldung: 09.09.2020
(73) Patentinhaber: Diehl Metering GmbH, 91522 Ansbach (DE)
(72) Erfinder: Baer, Malte, 38159 Vechelde (DE)
(74) Vertreter: Diehl Patentabteilung

(56) Entgegenhaltungen:
- WO-A1-2018/198419
- WO-A1-2018/198419
- CA-A1- 2 987 661
- CA-A1- 2 987 661
- CN-U- 204 154 346
- CN-U- 204 154 346
- CN-U- 207 850 456
- CN-U- 207 850 456
- CN-U- 208 140 211
- CN-U- 208 140 211
- DE-U1- 202018 102 622
- JP-A- 2012 078 231
- JP-A- 2012 078 231

## Beschreibung

Die Erfindung betrifft einen Fluidzähler gemäß dem Oberbegriff des Anspruchs 1.

Derartiger Fluidzähler kommen in unterschiedlichen Anwendungsbereichen zum Einsatz. Am bekanntesten sind Wasserzähler. Ein solcher Fluidzähler umfasst eine Elektronikeinheit, oft auch als Rechenwerk bezeichnet, mit einer Elektronikeinrichtung, die die über eine entsprechende Messstrecke aufgenommenen Messwerte verarbeitet und mittels einer Anzeigereinrichtung, zumeist einem Display, wiedergibt. Für den Betrieb der Elektronikeinrichtung, zu der auch die Messsensoren zählen, ist im Gehäuse ebenfalls eine Energiespeichereinrichtung, also ein Batteriemodul vorgesehen, das energieübertragend mit der Elektronikeinrichtung gekoppelt ist, was zumeist über eine entsprechende Kabelverbindung realisiert ist. Alternativ ist auch eine induktive Energieübertragungsschnittstelle vorgesehen.

CN 207 850 456 U betrifft einen Gaszähler mit einer Elektronikeinrichtung und einer Energiespeichereinrichtung mit einem in einer Vergussmasse eingegossenen Energiespeicher. Weitere Fluidzähler sind aus CN 204 154 346 U, WO 2018/198419 A1, JP 2012 078231 A und CN 208 140 211 U bekannt.

Mitunter sind Fluidzähler derart ausgelegt, dass sie auch im Fluid untergetaucht, also beispielsweise unter Wasser, montiert werden können. Dies setzt voraus, dass das Gehäuse der Elektronikeinheit hermetisch abgedichtet ist, sodass verhindert wird, dass auch nur geringste Mengen an Fluid in das Gehäuse eintreten können. Ein solches Abdichtkonzept ist äußerst aufwendig im Hinblick auf die gegebenen Dichtigkeitsanforderungen.

Mitunter ist die Energiespeichereinrichtung auszutauschen, wenn der Zähler lange Zeit in Betrieb war. Hierzu ist zwangsläufig das Zählergehäuse zu öffnen, sei es vollständig, sei es nur im Bereich einer Batterieöffnung, über die ein Zugriff zur Energiespeichereinrichtung möglich ist. In jedem Fall aber wird die hermetische Abdichtanordnung hierbei in Mittleidenschaft gezogen, da das Gehäuse eben vollständig oder lokal geöffnet wird. Nach Austausch der Energiespeichereinrichtung ist es erneut erforderlich, die Dichtheit herzustellen, was mit beachtlichem Aufwand verbunden ist.

Der Erfindung liegt damit das Problem zu Grunde, einen demgegenüber verbesserten Fluidzähler anzugeben.

Zur Lösung dieses Problems ist erfindungsgemäß ein Fluidzähler gemäß Anspruch 1 vorgesehen.

Bei dem erfindungsgemäßen Fluidzähler bzw. der erfindungsgemäßen Elektronikeinheit ist eine separat vergossene Elektronikeinrichtung sowie eine separat vergossene Energiespeichereinrichtung, also eine separat vergossene Batterieeinheit vorgesehen, die als separate Vergussbaugruppen vollständig dicht vergossen vorgefertigt hergestellt werden können und anschließend im Rahmen der Montage im Gehäuse verbaut werden können. Die Kopplung zur Energieübertragung kann über eine Kabelverbindung erfolgen, wozu beide über eine oder mehrere Verbindungskabel miteinander verbunden sind. Diese Verbindungskabel können an den entsprechenden Anschlüssen, die hinreichend abgedichtet sind, an der Elektronikeinrichtung oder an der Energiespeichereinrichtung angeschlossen sein, wobei erfindungsgemäß vorgesehen ist, dass die angeschlossenen Enden in der Vergussmasse der Elektroeinrichtung respektive der Energiespeichereinrichtung eingegossen sind. Alternativ zur Kabelverbindung ist es auch denkbar, eine induktive Energieübertragungsschnittstelle vorzusehen, das heißt, dass die entsprechenden Übertragungselemente einerseits in der vergossenen Elektronikeinrichtung und andererseits in der vergossenen Energiespeichereinrichtung vorgesehen sind und in der Montagestellung so zueinander positioniert sind, dass eine Energieübertragung möglich ist.

Infolge des direkten separaten Vergusses der beiden Einrichtungen und im Fall der Kopplung beider über eine Kabelverbindung, im Rahmen welcher natürlich zweckmäßigerweise ein fluidresistentes Kabel verwendet wird, ist eine maximale Fluid- oder respektive Medienbeständigkeit sichergestellt, wenn der Fluidzähler hergestellt und erstmals ausgeliefert respektive verbaut wird. Durch den Verguss ist vollständige Sicherheit gegen ein Eindringen des Fluides auch im Fall einer Unterwassermontage in die kritischen Bereiche der Elektronikeinrichtung respektive der Energiespeichereinrichtung gegeben. Seitens des die beiden Einrichtungen aufnehmenden Gehäuses sind im Idealfall keine zuhörigen Abdichtmittel vorzusehen, nachdem infolge des Vergusses das Gehäuse auch durchaus im Montagefall mit dem Fluid geflutet werden kann, ohne das die Funktionalität auch nur ansatzweise beeinträchtigt wird. Selbstverständlich besteht die Möglichkeit, eine einfache Gehäuseabdichtung vorzusehen, die dann aber in keinen Fall die hohe Anforderung in eine vollständige Mediendichtheit erfüllen muss.

Ein besonderer Vorteil des erfindungsgemäßen Fluidzählers neben der vollständigen Dichtheit der relevanten Komponenten liegt ferner darin, dass ein Austausch der Energiespeichereinrichtung im Bedarfsfall möglich ist. Denn es ist lediglich erforderlich, nach Öffnen des Gehäuses die Energiespeichereinrichtung zu entnehmen, wozu entweder im Fall einer Kabelverbindung die Kabelverbindung durchtrennt werden muss, wonach eine neue vergossene Energiespeichereinrichtung eingesetzt und mit ihrem Kabelabschnitt an den verbleibenden, von der Elektronikeinrichtung kommenden Kabelabschnitt angeschlossen wird, wobei natürlich diese Verbindung abgedichtet sein bzw. werden muss. Im Fall einer induktiven Energieübertragung muss keine zusätzliche Abdichtung mehr erfolgen, sondern lediglich ein Austausch.

In keinem Fall aber muss zusätzlich zum Austausch eine aufwendige, umfassende Gehäuseabdichtung erfolgen, da erneut alle beteiligten Komponenten vollständig vergossen sind und selbst im Fall einer neu verbundenen Kabelverbindung dieser Verbindungsbereich dicht ist. Die Dichtigkeit in diesem Bereich kann durch Verwendung entsprechender dichter oder selbständig abdichtender Kabelverbinder wie beispielsweise eines Klemm-Schneid-Verbinders realisiert werden. Die Verwendung eines solchen Verbinders stellt gerade eine hinreichende hohe Dichtigkeit sicher, sodass durchaus auch allein durch Verwendung eines solchen Verbinders eine Unterwassermontage wieder möglich ist. Natürlich besteht die Möglichkeit, auch diese Anschlusseinrichtung respektive diesen Klemm-Schneid-Verbinder nachträglich nochmals separat abzudichten bzw. zu vergießen, worauf nachfolgend noch angehängt wird.

Neben dem Fluidzähler selbst betrifft die Erfindung ferner eine Energiespeichereinrichtung für einen Fluidzähler der vorstehend beschriebenen Art. Die erfindungsgemäße Energiespeichereinrichtung weist die Merkmale des Anspruchs 3 auf.

Diese Energiespeichereinrichtung zeichnet sich also dadurch aus, dass sie vollständig vergossen ist, das heißt, dass die Speicherzellen in dem Vergussgehäuse komplett eingegossen sind. Aus der Vergussmasse ragt entweder ein Kabelabschnitt hervor, an dem bereits vorkonfiguriert eine entsprechende Anschlusseinrichtung zum Verbinden mit dem entsprechenden Kabelabschnitt der Elektronikeinrichtung angeordnet ist, das heißt, dass lediglich deren Kabelabschnitt noch an der Anschlusseinrichtung anzuschließen ist. Alternativ kann die Energiespeichereinrichtung auch ein vergossenes Schnittstellenbauteil für eine induktive Energieübertragung umfassen.

Diese Energiespeichereinrichtung kann also komplett vorkonfiguriert werden, so dass ein etwaiger Austausch äußerst einfach vonstatten gehen kann.

Die Anschlusseinrichtung ist bevorzugt ein Klemm-Schneid-Verbinder, der ein vorzugsweise wiederum medien- oder fluiddichtes Verbinden der Kabelabschnitte ermöglicht.

Des Weiteren betrifft die Erfindung ein Verfahren zum Austausch einer Energiespeichereinrichtung eines Fluidzählers der vorstehend beschriebenen Art unter Verwendung eines Energiespeichers der vorstehend beschriebenen Art, wobei das erfindungsgemäße Verfahren die Merkmale des Anspruchs 5 aufweist.

Im Rahmen dieses Verfahrens kann vorgesehen sein, dass eine die vergossene Elektronikeinrichtung und die vergossene Energiespeichereinrichtung verbindende Kabelverbindung des Fluidzählers bzw. der Elektronikeinheit aufgetrennt wird und an dem verbleibenden Kabelabschnitt der Elektronikeinrichtung die am Kabelabschnitt der neuen Energiespeichereinrichtung angeordnete Anschlusseinrichtung angeschlossen wird. Weist der wieder funktionsfähig zu machende Fluidzähler bzw. die instandzusetzende Elektronikeinheit folglich eine Kabelverbindung auf, so wird diese auf einfache Weise aufgetrennt, also durchgeschnitten und anschließend nach Einsetzen der neuen Energiespeichereinrichtung die an dieser vorgesehenen Anschlusseinrichtung mit dem freien Kabelende der Elektronikeinrichtung verbunden. Kommt ein Klemm-Schneid-Verbinder zum Einsatz, so wird demzufolge das freie Kabelende an diesem angeschlossen.

Sollte diese Anschlusseinrichtung noch nicht bereits von Haus aus fluid- oder mediendicht sein, wie dies beispielsweise für einen entsprechend ausgelegten Klemm-Schneid-Verbinder der Fall sein kann, so besteht die Möglichkeit, die Anschlusseinrichtung nach dem Verbinden der beiden Kabelabschnitte mit einer Vergussmasse zu vergießen, wobei natürlich auch ein solcher Klemm-Schneid-Verbinder nochmal zusätzlich vergossen werden kann.

Dabei kann die Anschlusseinrichtung in einen Gehäusebereich eingesetzt werden, der anschließend mit der Vergussmasse vergossen wird. Im Gehäuse der Elektronikeinheit kann folglich bereits ein entsprechender, z.B. räumlich über entsprechende Wände abgegrenzte Gehäusebereich vorgesehen sein, in den die Anschlusseinrichtung eingesetzt wird, und der anschließend mit der Vergussmasse ausgegossen wird. Die Anschlusseinrichtung wird über die Vergussmasse folglich fest am Gehäuse ein- bzw. angegossen.

Alternativ besteht die Möglichkeit, um die Anschlusseinrichtung ein separates Gehäuse, beispielsweise bestehend aus zwei Halbschalen, die entweder separat sind oder aneinander schwenkbar angelenkt sind, zu legen und anschließend dieses Gehäuse mit der Vergussmasse auszugießen, also das Gehäuse als Gießform zu verwenden. Dieses Gehäuse verbleibt gegebenenfalls sodann an der vergossenen Anschlusseinrichtung.

Alternativ zum Vergießen besteht auch die Möglichkeit, die Anschlusseinrichtung in einem Bereich innerhalb des Gehäuses der Elektronikeinheit anzuordnen, in dem sich in der Montagestellung unter Fluid eine Luftblase bildet. Die Anschlusseinrichtung wird also in einem Gehäusebereich positioniert, wo sich, wenn der erneut funktionsfähige Fluidzähler wieder unter Wasser gesetzt wird, eine Luftblase ausbildet, so dass die Anschlusseinrichtung, die wie beschrieben zweckmäßigerweise von Haus aus eine hohe Mediendichtheit aufweist, nicht mit dem Fluid, also beispielsweise Wasser, in Berührung kommt. Auch hierüber kann ein hinreichendes, noch weitergehendes Sicherheitsniveau erreicht werden.

Für den Fall, dass der erneut funktionsfähig zu machende Fluidzähler bzw. die Elektronikeinheit über eine Energieübertragungsschnittstelle verfügt, ist es für die Instandsetzung lediglich erforderlich, die alte Energiespeichereinrichtung gegen einer neue auszutauschen und sodann das Gehäuse wieder anzuschließen. Beim Austausch ist natürlich sicherzustellen, dass das Energieübertragungsschnittstellenbauteil der neuen Energiespeichereinrichtung korrekt bezüglich des entsprechenden Bauteils an der Elektronikeinrichtung positioniert ist. Dies kann auf einfache Weise dadurch geschehen, dass gehäuseseitig eine entsprechende, eine exakte und definierte Positionierung der Energiespeichereinrichtung ermöglichende Führung oder Aufnahme vorgesehen ist.

Nachfolgend wird ein Fluidzähler erläutert, der nach dem erfindungsgemäßen, vorstehend beschriebene Verfahren hergestellt wurde, also wieder funktionstüchtig gemacht wurde. Dieser Fluidzähler zeichnet sich dadurch aus, dass die vergossene Elektronikeinrichtung und die vergossene Energiespeichereinrichtung über eine Kabelverbindung, die zwei über eine Anschlusseinrichtung verbundene Kabelabschnitte aufweist, von denen einer an der Elektronikeinrichtung und der andere an der Energiespeichereinrichtung angeschlossen ist, verbunden sind.

Dabei kann die Anschlusseinrichtung, sofern erforderlich, zusätzlich mit einer Vergussmasse vergossen sein, wozu sie entweder in einem Gehäusebereich angeordnet ist, der mit der Vergussmasse ausgegossen ist. Alternativ dazu kann um die Anschlusseinrichtung auch ein Gehäuse angeordnet sein, das anschließend mit der Vergussmasse angegossen ist.

Weiteren kann alternativ oder zusätzlich vorgesehen sein, dass die Anschlusseinrichtung in einem Bereich innerhalb des Gehäuses des Fluidzählers angeordnet ist, in dem sich in der Montagestellung unter Fluid eine Luftblase bildet.

Weitere Vorteile und Einzelheiten der Erfindung ergeben sich aus den folgenden Ausführungsbeispielen sowie den zugehörigen Zeichnungen. Hierbei zeigen schematisch:
- Fig. 1: eine Prinzipdarstellung einer Elektronikeinheit bzw. ein Rechenwerk eines erfindungsgemäßen Fluidzählers mit geöffnetem Gehäuse vor der erneuten Instandsetzung durch Austausch der Energiespeichereinrichtung,
- Fig. 2: die unterseitige Ansicht der Elektronikeinrichtung und der über eine Kabelverbindung damit verbundenen Energiespeichereinrichtung,
- Fig. 3: die Anordnung gemäß Fig. 1 während des Austauschvorgangs und dem Auftrennen der Kabelverbindung,
- Fig. 4: eine Perspektivansicht einer neuen erfindungsgemäßen Energiespeichereinrichtung, die zum Austausch vorgesehen ist,
- Fig. 5: die Energiespeichereinrichtung aus Fig. 4 in einer anderen Perspektivansicht,
- Fig. 6: die Anordnung während des Verbindungsvorgangs der Energiespeichereinrichtung mit der Elektronikeinrichtung,
- Fig. 7: die neu instandgesetzte Elektronikeinheit mit geöffnetem Gehäuse,
- Fig. 8: die Elektronikeinheit aus Fig. 7, wobei die Elektronikeinrichtung und die Energiespeichereinrichtung in der anderen Gehäusehälfte aufgenommen sind,
- Fig. 9: die Möglichkeit des nachträglichen Vergusses der Anschlusseinrichtung, und
- Fig. 10: eine geschnittene Prinzipdarstellung des instandgesetzten Fluidzählers.

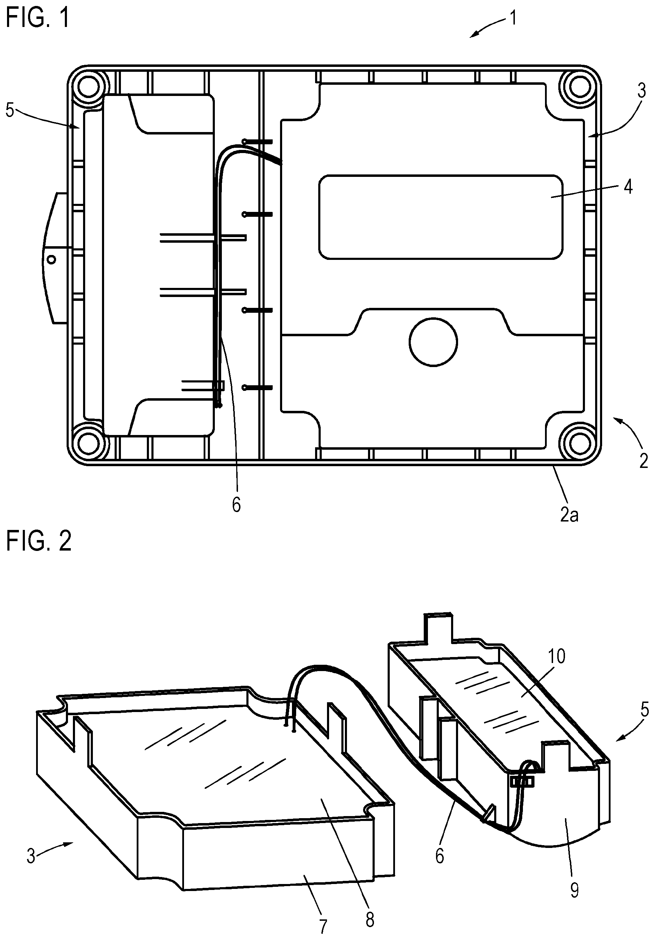

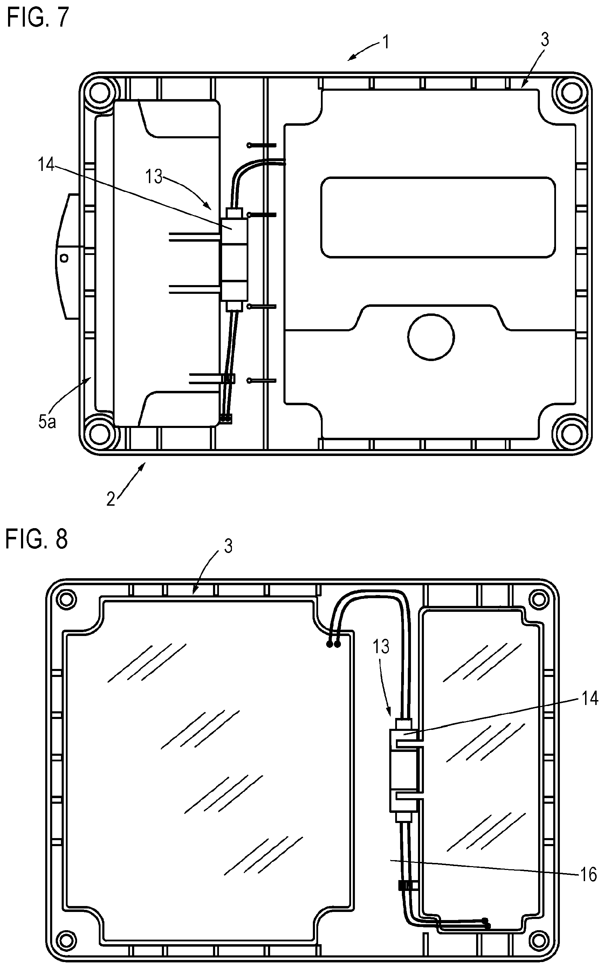

Fig. 1 zeigt eine Elektronikeinheit 1 als Teil eines erfindungsgemäßen Fluidzählers, beispielsweise ein Wasserzähler in Form eines Haus- oder Großwasserzählers. Die Elektronikeinheit 1 umfasst ein Gehäuse 2, das bevorzugt aus zwei Gehäuseschalen besteht, wobei in Fig. 1 lediglich die eine Gehäuseschale 2a gezeigt ist, während in Fig. 8 exemplarisch bei einem geöffneten Gehäuse die zweite Gehäuseschale 2b gezeigt ist.

Im Inneren des Gehäuses 2 befindet sich eine Elektronikeinrichtung 3, die sämtliche relevanten Mess- und Verarbeitungselemente wie Sensoren, Rechen- und Verarbeitungs- oder spezifische Steuerungseinrichtung sowie eine Anzeigeeinrichtung 4 umfasst. Im Gehäuse 2 ist des Weiteren auch eine Energiespeichereinrichtung 5 beispielsweise in Form einer entsprechend leistungsfähigen, eine entsprechende Anzahl an Energiespeicherzellen oder Module umfassenden Batterie vorgesehen, die mit der Elektronikeinrichtung 3 über eine Kabelverbindung 6 verbunden ist. Alternativ zu einer solchen Kabelverbindung kann auch eine induktive Energieübertragungsschnittstelle mit den entsprechenden Übertragungsbauteilen an der Elektronikeinrichtung 3 und der Energiespeichereinrichtung 5 vorgesehen sein.

Fig. 2 zeigt die relevanten Elemente, nämlich die Elektronikeinrichtung 3 sowie die Energiespeichereinrichtung 5 separat von der Unterseite her, wobei an dieser Darstellung ersichtlich ist, dass die Elektronikeinrichtung 3 ein Vergussgehäuse 7 aufweist, in dem die entsprechenden Komponenten angeordnet sind, und das mit einer Vergussmasse 8 vergossen ist. Ebenso weist auch die Energiespeichereinrichtung 5 ein Vergussgehäuse 9 auf, in dem die Speicherzellen oder Speichermodule aufgenommen sind, und das ebenfalls mit einer Vergussmasse 10 ausgegossen ist. Die zweiadrige Kabelverbindung 6 ist an den entsprechenden Anschlusspolen der Elektronikeinrichtung 3 und der Energiespeichereinrichtung 5 angeschlossen und mit den entsprechenden Anschlüssen respektive Leistungsenden ebenfalls in der jeweiligen Vergussmasse 8, 10 vergossen. Es ist demzufolge eine völlige Mediendichtheit sowohl seitens der Elektronikeinrichtung 3 als auch der Energiespeichereinrichtung 5 vorgesehen, wie auch seitens der Kabelverbindung 6, die natürlich mit einer entsprechenden, medienresistenten Kunststoffummantelung etc. versehen ist.

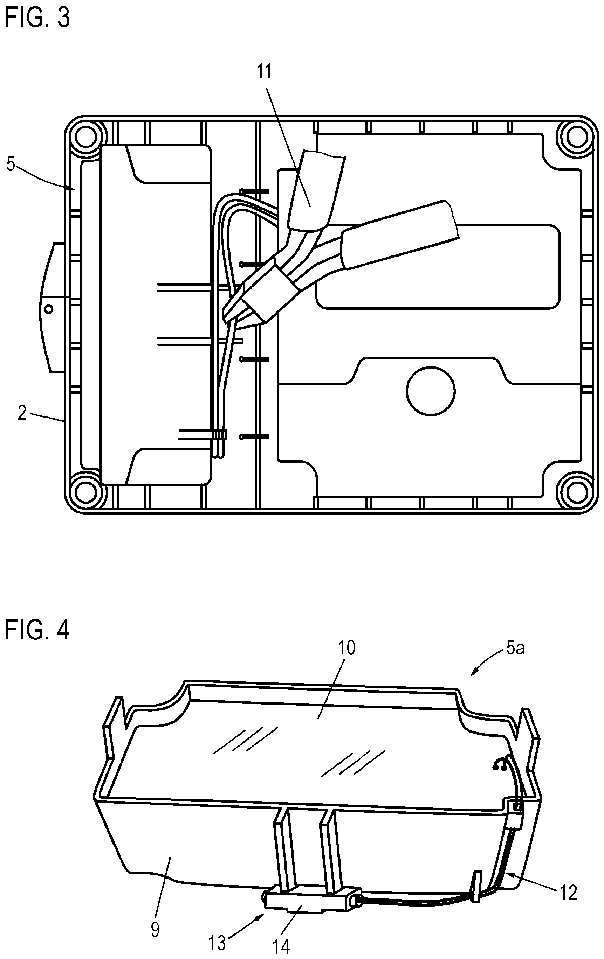

Es sei angenommen, dass die Energiespeichereinrichtung 5 auszutauschen ist, entweder weil defekt, oder weil die Speicherkapazität zu niedrig ist. Dies geschieht, indem die Kabelverbindung 6, siehe Fig. 3, mittels eines einfachen Schneidwerkzeugs 11 aufgetrennt wird, sie wird also einfach durchtrennt, sodass die defekte oder auszutauschende Energiespeichereinrichtung 5 dem Gehäuse 2 entnommen werden kann.

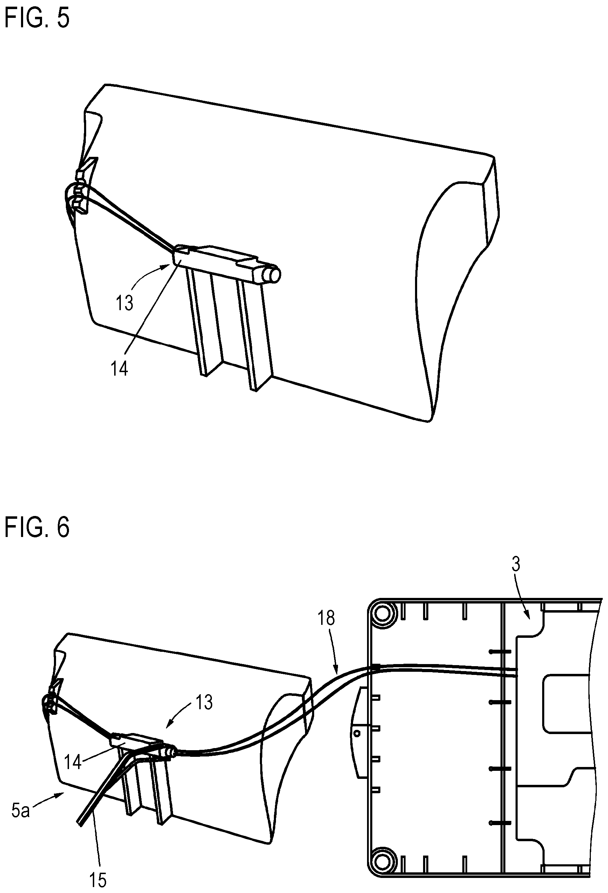

Die Fig. 4 und 5 zeigen eine neue, voll funktionsfähige Energiespeichereinrichtung 5a, die im gezeigten Beispiel in identischer Weise ein Vergussgehäuse 9, in dem die Speicherzellen oder Speichermodul aufgenommen sind, aufweist, das mit einer Vergussmasse 10 ausgegossen ist. Die Geometrie der neuen Energiespeichereinrichtung 5a entspricht im Wesentlichen oder vollständig der Geometrie der auszutauschenden Energiespeichereinrichtung, sodass die neue Energiespeichereinrichtung 5a entsprechend positioniert werden kann.

Die neue Energiespeichereinrichtung 5a weist einen aus der Vergussmasse 10 herausgeführten Kabelabschnitt 12 auf, an dem eine Anschlusseinrichtung 13 in Form eines Klemm-Schneid-Verbinders 14 bereits von Haus aus vorkonfiguriert angeschlossen ist.

Mittels dieser Anschlusseinrichtung 13 respektive dieses Klemm-Schneid-Verbinders 14 erfolgt nun die Kontaktierung zu der Elektronikeinrichtung 3 respektive deren Kabelabschnitt 18, der nach Durchtrennen der Kabelverbindung 6 dortseits verblieben ist. Die beiden Kabel oder Litzen werden in die Klemm-Schneid-Verbinder 14 eingesteckt, wonach diese mit einem Werkzeug 15 entsprechend gequetscht wird (siehe Fig. 6). Es bildet sich eine feste, je nach Auslegung der Anschlusseinrichtung 13 erneut mediendichte und damit die Verbindungsstelle schützende Kabelverbindung aus.

Fig. 7 zeigt nun die Anordnung der Elektronikeinheit 1 des Fluidzählers ähnlich der aus Fig. 1, jedoch ist hier die neue Energiespeichereinrichtung 5a verbaut respektive im Gehäuse 2 eingesetzt. Ersichtlich findet die Anschlusseinrichtung 13 gut Platz innerhalb des Gehäuses 2, wie auch die Fig. 8 zeigt, in der das Gehäuse 2 mit der zweiten Gehäusehälfte 2b gezeigt ist, mithin also die Elektronikeinrichtung 3 sowie die neue Energiespeichereinrichtung 5a von der Unterseite zu sehen sind. Ersichtlich befindet sich die Anschlusseinrichtung 13, also der Klemm-Schneid-Verbinder 14, an der Unterseite der Gehäuseschale 2b, die, in Bezug auf die Montagestellung, den oberen Gehäusedeckel bildet.

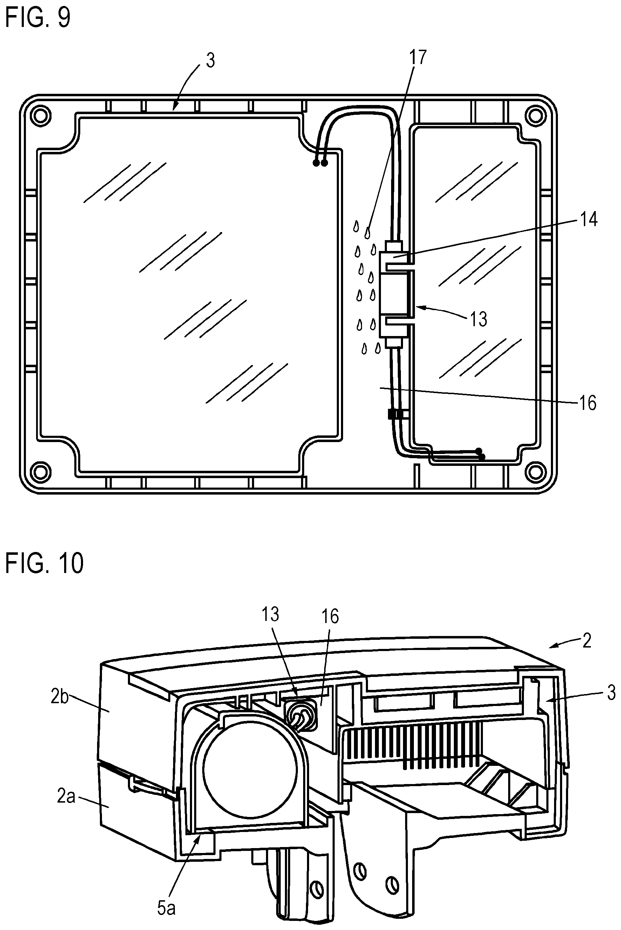

Wenn die Anschlusseinrichtung 13 bereits eine hinreichende Mediendichtheit bietet, verbunden mit einem entsprechenden Korrosionsschutz der in ihr erfolgten Kabelverbindung etc., so sind keine weiteren Maßnahmen hinsichtlich eine zusätzliche Abdichtung der Anschlusseinrichtung 13 erforderlich. Falls die Anschlusseinrichtung 13 dies nicht zwingend gewährleistet, oder falls dies aus Vorschriftsgründen dennnoch erforderlich ist, zeigt Fig. 9 die Möglichkeit, die Anschlusseinrichtung 13, die in dem entsprechenden Gehäusebereich 16 aufgenommen ist, in diesem Bereich ebenfalls mit einer Vergussmasse 17 auszugießen, wie durch die Tröpfchensymbole in Fig. 9 dargestellt ist. Das heißt, dass in diesem Abschnitt die entsprechende flüssige oder pastöse Vergussmasse eingebracht wird, sodass die Anschlusseinrichtung 13 vollständig in dieser eingebettet und damit nachträglich definitiv abgedichtet ist.

Zusätzlich oder alternativ hierzu besteht auch die Möglichkeit, siehe Fig. 10, die Anschlusseinrichtung 13 so in dem Gehäuse 2 respektive in einem Gehäusebereich 16 anzuordnen, dass die Anschlusseinrichtung 13 in der Montagestellung, wenn also der Fluidzähler wieder unter Wasser montiert wird, sie sich in einem Bereich bildet, in dem sich eine Luftblase bildet, wenn Flüssigkeit, also Wasser, in das Gehäuse 2 eindringt. Aufgrund der Geometrie des Gehäuseteils 2b sammelt sich trotz eindringenden Wassers die verdrängte Luft im oberen Bereich des Gehäuseteils 2b, mithin also auch im Gehäusebereich 16, in dem die Anschlusseinrichtung 13 aufgenommen ist, sodass sich eine Art Luftpolster bildet, das die Anschlusseinrichtung 13 aufnimmt und schützt, sodass trotz erfolgten Batteriewechsels wiederum die hohe Schutzklasse sichergestellt ist.

Der Fluidzähler ist demzufolge bei einer untergetauchten Montage wiederum vollständig geschützt und volleinsatzfähig, auch ein Überflutungsschutz und dergleichen ist sichergestellt.

Die Erfindung erlaubt demzufolge einen einfachen Austausch einer Energieversorgungseinrichtung, wobei die Elektronikeinheit 1 sehr einfach gestaltet ist, an dieser sind keinerlei spezifische Abdichtmittel vorzusehen, um das Gehäuseinnere abzudichten. Denn aufgrund des vollständigen Vergusses der Elektronikeinrichtung 3 sowie der Energiespeichereinrichtung 5 respektive 5a und, im Austauschfall, gegebenenfalls auch der Anschlusseinrichtung 13 ist ein störungsfreier und sicherer Betrieb gewährleistet.

Darüber hinaus bietet dieses modulare Konzept auch die Möglichkeit, eine Elektronikeinrichtung 3 eines Fluidzählers im Fall eines Austauschs der Energiespeichereinrichtung 5a auch mit einem anderen Batterietyp zu koppeln. Beispielsweise kann eine sehr kompakte Elektronikeinrichtung 3 eines Haushaltswasserzählers durch das Hinzufügen einer größeren D-Zelle im Batteriefach auch für einen Großwasserzähler mit erhöhtem Energiebedarf, aber ohne Bauraumbeschränkungen, genutzt werden.

Ist eine induktive Energieübertragung, also eine drahtlose Energieübertragung vorgesehen, so ist lediglich, wie vorstehend bereits beschrieben, die Energiespeichereinrichtung 5 auszutauschen. Hier sind keinerlei zusätzlichen Kontaktierungs- oder Abdichtmaßnamen seitens der Anschlusseinrichtung 13 etc. vorzunehmen, sodass der Fluidzähler 1 anschließend erneut vollfunktions- und einsatzbereit ist. Auch in diesem Fall sind aufgrund des vollständigen Vergusses der beiden beteiligten Einrichtungen keinerlei separate Abdichtmaßnahmen am Gehäuse 2 vorzusehen, dass in diesem Fall ebenfalls äußerst einfach konfiguriert sein kann.

## Patentansprüche

1. Fluidzähler mit einer Elektronikeinheit (1) umfassend ein Gehäuse (2), in dem eine Elektronikeinrichtung (3) sowie eine dieser zugeordnete, sie versorgende austauschbare Energiespeichereinrichtung (5, 5a) angeordnet ist, **dadurch gekennzeichnet, dass** sowohl die Elektronikeinrichtung (3) als auch die Energiespeichereinrichtung (5, 5a) separat mit einer Vergussmasse (8, 10) vollständig vergossen sind und entweder über eine Kabelverbindung (6), deren eines Ende in der Vergussmasse (8) der Elektronikeinrichtung (3) und deren anderes Ende in der Vergussmasse (9) der Energiespeichereinrichtung (5, 5a) eingegossen ist, oder über eine induktive Energieübertragungsschnittstelle miteinander gekoppelt sind.

2. Fluidzähler nach Anspruch 1, **dadurch gekennzeichnet, dass** die Kabelverbindung (6) fluidresistent ist.

3. Energiespeichereinrichtung ausgeführt für einen Fluidzähler nach einem der vorangehenden Ansprüche, ausgeführt zum Ersetzen der bereits im Fluidzähler (1) vorhandener austauschbaren Energiespeichereinrichtung (5), **dadurch gekennzeichnet, dass** in einem Vergussgehäuse (9) eine oder mehrere Speicherzellen aufgenommen und mit einem aus dem Vergussgehäuse (9) geführten Kabelabschnitt (12) oder einem in dem Vergussgehäuse (9) angeordneten induktiven Energieübertragungsschnittstellenbauteil gekoppelt sind, wobei die Speicherzellen und das im Vergussgehäuse (9) befindliche Ende der Kabelverbindung oder das Energieübertragungsschnittstellenbauteil mit einer Vergussmasse (10) vollständig vergossen sind, wobei an dem Kabelabschnitt (12) eine Anschlusseinrichtung (13) zum Verbinden mit einem mit der Elektronikeinrichtung (3) des Fluidzählers (1) angeordneten, nach dem Abtrennen der auszutauschenden Energiespeichereinrichtung (5) verbleibenden Kabelabschnitt (18) vorgesehen ist.

4. Energiespeichereinrichtung nach Anspruch 3, wobei die Elektronikeinrichtung (3) und die Energiespeichereinrichtung (5, 5a) über die Kabelverbindung (6) miteinander koppelbar sind, **dadurch gekennzeichnet, dass** die Anschlusseinrichtung (13) ein Klemm-Schneid-Verbinder (14) ist.

5. Verfahren zum Austausch einer Energiespeichereinrichtung (5) eines Fluidzählers nach einem der Ansprüche 1 oder 2 unter Verwendung einer Energiespeichereinrichtung (5a), wobei die Energiespeichereinrichtung (5a) für einen Fluidzähler nach einem Ansprüche 1 oder 2 und zum Ersetzen der bereits im Fluidzähler (1) vorhandener austauschbaren Energiespeichereinrichtung (5) ausgeführt ist, wobei für die Energiespeichereinrichtung (5a) vorgesehen ist, dass in einem Vergussgehäuse (9) eine oder mehrere Speicherzellen aufgenommen und mit einem aus dem Vergussgehäuse (9) geführten Kabelabschnitt (12) oder einem in dem Vergussgehäuse (9) angeordneten induktiven Energieübertragungsschnittstellenbauteil gekoppelt sind, und dass die Speicherzellen und das im Vergussgehäuse (9) befindliche Ende der Kabelverbindung oder das Energieübertragungsschnittstellenbauteil mit einer Vergussmasse (10) vergossen sind, sodass Anschlüsse der Energiespeichereinrichtung (5a), an denen die Kabelverbindung (6) angeschlossen, in der Vergussmasse (10) vergossen sind, wobei an dem Kabelabschnitt (12) eine Anschlusseinrichtung (13) zum Verbinden mit einem mit der Elektronikeinrichtung (3) des Fluidzählers (1) angeordneten, nach dem Abtrennen der auszutauschenden Energiespeichereinrichtung (5) verbleibenden Kabelabschnitt (18) vorgesehen ist, wobei,
- wenn die Elektronikeinrichtung (3) und die Energiespeichereinrichtung (5, 5a) über die Kabelverbindung (6) miteinander gekoppelt sind, eine die vergossene Elektronikeinrichtung (3) und die vergossene Energiespeichereinrichtung (5) verbindende Kabelverbindung (6) aufgetrennt wird und an den verbleibenden Kabelabschnitt (18) an der Elektronikeinrichtung (3) die am Kabelabschnitt (12) der neuen Energiespeichereinrichtung (5a) angeordnete Anschlusseinrichtung (13) angeschlossen wird, oder,
- wenn die Elektronikeinrichtung (3) und die Energiespeichereinrichtung (5, 5a) über die induktive Energieübertragungsschnittstelle miteinander gekoppelt sind, ein Austausch der Energiespeichereinrichtung (5, 5a) ohne zusätzliche Abdichtung erfolgt.

6. Verfahren nach Anspruch 5, wobei die Elektronikeinrichtung (3) und die Energiespeichereinrichtung (5, 5a) über die Kabelverbindung (6) miteinander gekoppelt sind, **dadurch gekennzeichnet, dass** die Anschlusseinrichtung (13) nach dem Verbinden der beiden Kabelabschnitte (12, 18) mit einer Vergussmasse (17) vergossen wird.

7. Verfahren nach Anspruch 6, **dadurch gekennzeichnet, dass** die Anschlusseinrichtung (13) in einen Gehäusebereich (16) eingesetzt wird, der anschließend mit der Vergussmasse (17) ausgossen wird.

8. Verfahren nach Anspruch 6, **dadurch gekennzeichnet, dass** um die Anschlusseinrichtung (13) ein Gehäuse angeordnet wird, das anschließend mit der Vergussmasse (17) ausgegossen wird.

9. Verfahren nach Anspruch 5, wobei die Elektronikeinrichtung (3) und die Energiespeichereinrichtung (5, 5a) über die Kabelverbindung (6) miteinander gekoppelt sind, **dadurch gekennzeichnet, dass** die Anschlusseinrichtung (13) in einem Bereich (16) innerhalb des Gehäuses (2) des Fluidzählers (1) angeordnet wird, in dem sich in der Montagestellung unter Fluid eine Luftblase bildet.

## Claims

1. Fluid counter having an electronics unit (1) comprising a housing (2) in which the electronics device (3) and an exchangeable energy storage device (5, 5a) associated with the electronics device and supplying power to the electronics device is arranged, **characterized in that** both the electronics device (3) and the energy storage device (5, 5a) are separately completely potted with a potting compound (8, 10) and are coupled to one another either via a cable connection (6), one end of which is incorporated in the potting compound (8) of the electronics device (3) and the other end of which is incorporated the potting compound (9) of the energy storage device (5, 5a), or via an inductive energy transmission interface.

2. Fluid counter according to Claim 1, **characterized in that** the cable connection (6) is fluid-resistant.

3. Energy storage device designed for a fluid counter according to either of the preceding claims, designed for replacing the exchangeable energy storage device (5) already present in the fluid counter (1), **characterized in that** one or more storage cells are accommodated in a potting housing (9) and coupled to a cable section (12) guided out of the potting housing (9) or to an inductive energy transmission interface component arranged in the potting housing (9), wherein the storage cells and the end of the cable connection that is located in the potting housing (9) or the energy transmission interface component are completely potted with a potting compound (10), wherein a connection device (13) for connection to a cable section (18) arranged with the electronics device (3) of the fluid counter (1) and remaining after disconnection of the energy storage device (5) to be exchanged is provided on the cable section (12).

4. Energy storage device according to Claim 3, wherein the electronics device (3) and the energy storage device (5, 5a) can be coupled to one another via the cable connection (6), **characterized in that** the connection device (13) is an insulation-displacement connector (14).

5. Method for exchanging an energy storage device (5) of a fluid counter according to either of Claims 1 and 2 using an energy storage device (5a), wherein the energy storage device (5a) is designed for a fluid counter according to either of Claims 1 and 2 and for replacing the exchangeable energy storage device (5) already present in the fluid counter (1), wherein provision is made for the energy storage device (5a) for one or more storage cells to be accommodated in a potting housing (9) and coupled to a cable section (12) guided out of the potting housing (9) or to an inductive energy transmission interface component arranged in the potting housing (9), and for the storage cells and the end of the cable connection that is located in the potting housing (9) or the energy transmission interface component to be potted with a potting compound (10), so that connections of the energy storage device (5a) to which the cable connection (6) is connected are potted in the potting compound (10), wherein a connection device (13) for connection to a cable section (18) arranged with the electronics device (3) of the fluid counter (1) and remaining after disconnection of the energy storage device (5) to be exchanged is provided on the cable section (12), wherein
- when the electronics device (3) and the energy storage device (5, 5a) are coupled to one another via the cable connection (6), a cable connection (6) connecting the potted electronics device (3) and the potted energy storage device (5) is disconnected and the connection device (13) arranged on the cable section (12) of the new energy storage device (5a) is connected to the remaining the cable section (18) on the electronics device (3), or,
- when the electronics device (3) and the energy storage device (5, 5a) are coupled to one another via the inductive energy transmission interface, the energy storage device (5, 5a) is exchanged without additional sealing.

6. Method according to Claim 5, wherein the electronics device (3) and the energy storage device (5, 5a) are coupled to one another via the cable connection (6), **characterized in that** the connection device (13) is potted with a potting compound (17) after the two cable sections (12, 18) are connected.

7. Method according to Claim 6, **characterized in that** the connection device (13) is inserted into a housing region (16) which is then filled with the potting compound (17).

8. Method according to Claim 6, **characterized in that** a housing is arranged around the connection device (13) and is then filled with the potting compound (17).

9. Method according to Claim 5, wherein the electronics device (3) and the energy storage device (5, 5a) are coupled to one another via the cable connection (6), **characterized in that** the connection device (13) is arranged in a region (16) within the housing (2) of the fluid counter (1), in which region an air bubble forms under fluid in the assembly position.

## Revendications

1. Compteur de fluide pourvu d'une unité électronique (1), comprenant un boîtier (2) dans lequel est disposé un dispositif électronique (3) ainsi qu'un dispositif d'accumulation d'énergie (5, 5a) échangeable, associé à celui-ci et alimentant celui-ci,
**caractérisé en ce qu'**à la fois le dispositif électronique (3) et le dispositif d'accumulation d'énergie (5, 5a) sont scellés entièrement avec une masse de scellement (8, 10), et sont couplés l'un à l'autre soit par une liaison par câble (6) dont une extrémité est scellée dans la masse de scellement (8) du dispositif électronique (3) et dont l'autre extrémité est scellée dans la masse de scellement (9) du dispositif d'accumulation d'énergie (5, 5a), soit par une interface de transmission d'énergie inductive.

2. Compteur de fluide selon la revendication 1, **caractérisé en ce que** la liaison par câble (6) résiste au fluide.

3. Dispositif d'accumulation d'énergie, réalisé pour un compteur de fluide selon l'une quelconque des revendications précédentes, réalisé pour remplacer le dispositif d'accumulation d'énergie (5) échangeable déjà en place dans le compteur de fluide (1), **caractérisé en ce que**, dans un boîtier scellé (9), une ou plusieurs cellules d'accumulation sont reçues et couplées à un tronçon de câble (12) acheminé à partir du boîtier scellé (9) ou à un composant d'interface de transmission d'énergie inductive disposé dans le boîtier scellé (9), dans lequel les cellules d'accumulation et l'extrémité de la liaison par câble qui se trouve dans le boîtier scellé (9), ou le composant d'interface de transmission d'énergie, sont entièrement scellés avec une masse de scellement (10), dans lequel, au niveau du tronçon de câble (12), est prévu un dispositif de connexion (13) pour être relié à un tronçon de câble (18) disposé avec le dispositif électronique (3) du compteur de fluide (1) et restant après la séparation du dispositif d'accumulation d'énergie (5) à échanger.

4. Dispositif d'accumulation d'énergie selon la revendication 3, dans lequel le dispositif électronique (3) et le dispositif d'accumulation d'énergie (5, 5a) peuvent être couplés l'un à l'autre par la liaison par câble (6), **caractérisé en ce que** le dispositif de connexion (13) est un connecteur autodénudant (14).

5. Procédé permettant d'échanger un dispositif d'accumulation d'énergie (5) d'un compteur de fluide selon l'une quelconque des revendications 1 ou 2 en utilisant un dispositif d'accumulation d'énergie (5a), dans lequel le dispositif d'accumulation d'énergie (5a) est réalisé pour un compteur de fluide selon l'une quelconque des revendications 1 ou 2 et pour remplacer le dispositif d'accumulation d'énergie (5) échangeable déjà en place dans le compteur de fluide (1), dans lequel il est prévu, pour le dispositif d'accumulation d'énergie (5a), que, dans un boîtier scellé (9), une ou plusieurs cellules d'accumulation soient reçues et couplées à un tronçon de câble (12) acheminé à partir du boîtier scellé (9) ou à un composant d'interface de transmission d'énergie inductive disposé dans le boîtier scellé (9), et que les cellules d'accumulation et l'extrémité de la liaison par câble qui se trouve dans le boîtier scellé (9), ou le composant d'interface de transmission d'énergie, soient scellés avec une masse de scellement (10), de sorte que les bornes du dispositif d'accumulation d'énergie (5a), auxquelles la liaison par câble (6) est raccordée, soient scellées dans la masse de scellement (10), dans lequel, au niveau du tronçon de câble (12), est prévu un dispositif de connexion (13) pour être relié à un tronçon de câble (18) disposé avec le dispositif électronique (3) du compteur de fluide (1) et restant après la séparation du dispositif d'accumulation d'énergie (5) à échanger, dans lequel,
- lorsque le dispositif électronique (3) et le dispositif d'accumulation d'énergie (5, 5a) sont couplés l'un à l'autre par la liaison par câble (6), une liaison par câble (6) reliant le dispositif électronique (3) scellé et le dispositif d'accumulation d'énergie (5) scellé est séparée, et le dispositif de connexion (13) disposé au niveau du tronçon de câble (12) du nouveau dispositif d'accumulation d'énergie (5a) sera connecté au tronçon de câble (18) restant au niveau du dispositif électronique (3), ou
- lorsque le dispositif électronique (3) et le dispositif d'accumulation d'énergie (5, 5a) sont couplés l'un à l'autre par l'interface de transmission d'énergie inductive, un échange du dispositif d'accumulation d'énergie (5, 5a) a lieu sans étanchéification supplémentaire.

6. Procédé selon la revendication 5, dans lequel le dispositif électronique (3) et le dispositif d'accumulation d'énergie (5, 5a) sont couplés l'un à l'autre par la liaison par câble (6), **caractérisé en ce que** le dispositif de connexion (13) est scellé avec une masse de scellement (17) après la liaison des deux tronçons de câble (12, 18).

7. Procédé selon la revendication 6, **caractérisé en ce que** le dispositif de connexion (13) est placé dans une zone de boîtier (16) qui est ensuite scellée avec la masse de scellement (17).

8. Procédé selon la revendication 6, **caractérisé en ce qu'**un boîtier est disposé autour du dispositif de connexion (13) qui est ensuite scellé avec la masse de scellement (17).

9. Procédé selon la revendication 5, dans lequel le dispositif électronique (3) et le dispositif d'accumulation d'énergie (5, 5a) sont couplés l'un à l'autre par la liaison par câble (6), **caractérisé en ce que** le dispositif de connexion (13) est disposé dans une zone (16) à l'intérieur du boîtier (2) du compteur de fluide (1) dans laquelle se forme une bulle d'air sous l'effet du fluide dans la position de montage.
